(19) Europäisches Patentamt / European Patent Office / Office européen des brevets

(11) **EP 4 779 324 A1**

(12) **EUROPEAN PATENT APPLICATION**
published in accordance with Art. 153(4) EPC

(43) Date of publication:
**22.07.2026 Bulletin 2026/30**

(21) Application number: **24865426.1**

(22) Date of filing: **10.09.2024**

(51) International Patent Classification (IPC):
**G01R 15/18** (2006.01)    **G01R 15/20** (2006.01)
**G01R 19/00** (2006.01)

(52) Cooperative Patent Classification (CPC):
**G01R 15/18; G01R 15/20; G01R 19/00**

(86) International application number:
**PCT/JP2024/032330**

(87) International publication number:
**WO 2025/057926 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.09.2023 JP 2023149392**

(71) Applicant: **Hioki E.E. Corporation**
**Ueda-shi, Nagano 386-1192 (JP)**

(72) Inventors:
• **KARASAWA, Yuki**
  **Ueda-shi, Nagano 386-1192 (JP)**
• **NAKAZAWA, Koki**
  **Ueda-shi, Nagano 386-1192 (JP)**
• **IKEDA, Kenta**
  **Ueda-shi, Nagano 386-1192 (JP)**
• **XIA, Peiyu**
  **Ueda-shi, Nagano 386-1192 (JP)**
• **YAMAGISHI, Kimihiko**
  **Ueda-shi, Nagano 386-1192 (JP)**

(74) Representative: **Novagraaf International SA**
**Chemin de l'Echo 3**
**1213 Onex, Geneva (CH)**

(54) **ELECTRIC CURRENT SENSOR, AND MEASURING DEVICE**

(57)    A current sensor includes a magnetic core configured to surround a measurement object with a current flowing therethrough, a detection winding wound around the magnetic core, a feedback winding wound around the magnetic core and supplied with a current output from an integrating circuit that integrates a voltage between both ends of the detection winding, and a capacitive element. In addition, the current sensor outputs, from an arithmetic circuit that adds a current output from the AC detection winding through the capacitive element and a current output from the feedback winding and converts the added current into a voltage, the converted voltage.

[FIG. 2]

EP 4 779 324 A1

## Description

## TECHNICAL FIELD

The present invention relates to a current sensor and a measuring device.

## BACKGROUND ART

WO2008-519269A discloses a circuit including an AC pickup winding that can detect an AC current having a frequency exceeding 1 Hz, and an auxiliary winding that generates an auxiliary current intended to cancel an electromotive force induced by a main current flowing through a conductor.

## SUMMARY OF INVENTION

In a current sensor including the circuit as described above, in a low-frequency band of approximately 1 kHz or less, magnetic flux generated in a magnetic core wound with both an AC detection winding corresponding to an AC pickup winding and a feedback winding corresponding to an auxiliary winding converges substantially to zero by zero flux operation.

However, as a frequency of the measurement current flowing through a measurement object becomes higher than the above-described low-frequency band, magnetic permeability of the magnetic core decreases, and influences of parasitic capacitance of each winding and inter-winding capacitance between the windings increase. As a result, a magnetic flux canceling operation by the feedback winding weakens, magnetic flux remains in the magnetic core, and an induced current flows in the AC detection winding.

Further, in a high-frequency band of approximately 10 kHz or more, due to an induced current flowing in the AC detection winding, the AC detection winding and the feedback winding wound around the magnetic core operate as a current transformer, resulting in a problem that a detection error with respect to the measurement current increases.

The present invention has been made in view of such a problem, and an object of the present invention is to suppress the detection error caused by the winding in the high-frequency band.

According to an aspect of the present invention, a current sensor includes a magnetic core configured to surround a measurement object with a current flowing therethrough, an AC detection winding wound around the magnetic core, a feedback winding wound around the magnetic core and supplied with a current output from an integrating circuit that integrates a voltage between both ends of the AC detection winding, and a capacitive element, in which the current sensor outputs, from an arithmetic circuit that adds a current output from the AC detection winding through the capacitive element and a current output from the feedback winding and converts the added current into a voltage (convert the added current into a voltage having a magnitude proportional to the magnitude of the added current), the converted voltage.

According to this aspect, in the high-frequency band, impedance of the capacitive element becomes low, and the current output from the AC detection winding through the capacitive element and the current output from the feedback winding are added, and thus the AC detection winding operates as a second feedback winding. Therefore, since an induced current of the AC detection winding becomes the current of the feedback winding and enhances the current of the feedback winding, the detection error caused by the winding in the high-frequency band can be suppressed.

## BRIEF DESCRIPTION OF DRAWINGS

FIG. 1 is a diagram illustrating a configuration of a measuring device including a current sensor according to a first embodiment.
FIG. 2 is a schematic diagram illustrating a configuration example of the current sensor.
FIG. 3 is a circuit diagram illustrating a detailed configuration example of the current sensor.
FIG. 4 is a diagram for explaining operation of the current sensor.
FIG. 5 is a diagram illustrating a simulation result of a gain frequency characteristic of the current sensor.
FIG. 6 is a circuit diagram illustrating a detailed configuration example of a current sensor according to a second embodiment.
FIG. 7 is a schematic diagram illustrating a configuration example of a current sensor according to a third embodiment.

## DESCRIPTION OF EMBODIMENTS

Embodiments of the present invention are described below with reference to the accompanying drawings. In the present specification, the same or equivalent elements are denoted by the same reference signs throughout.

First Embodiment

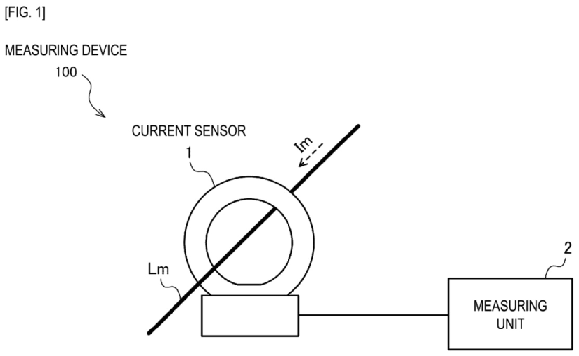

FIG. 1 is a diagram illustrating a configuration of a measuring device according to a first embodiment.

A measuring device 100 is a device for measuring a physical quantity of a measurement object Lm. The measurement object Lm is, for example, an electric path in which a DC or an AC measurement current Im flows, and examples of the electric path include, for example, a single-phase or a threephase power supply cable. Further, examples of the physical quantity of the measurement object Lm include a current value, a magnetic flux value, and a power value.

The measuring device 100 according to the first embodiment measures a magnitude of the measurement current Im flowing through the measurement object Lm. The measuring device 100 includes a current sensor 1 and a measuring unit 2.

The current sensor 1 is a sensor detecting magnetic flux generated by the AC measurement current Im. The current sensor 1 outputs, as a detection value, a voltage obtained by detecting the magnetic flux generated by the measurement current Im. The current sensor 1 is constituted by a magnetic core including a plurality of windings.

For example, the current sensor 1 is realized by a current sensor employing a winding detection type AC zero flux method (magnetic balance method), or by a current sensor including a magnetic detection element such as a fluxgate or a Hall element in addition to the method. The current sensor 1 may have a through-type structure surrounding the measurement object Lm, or may have a clamp-type structure that can be opened and closed.

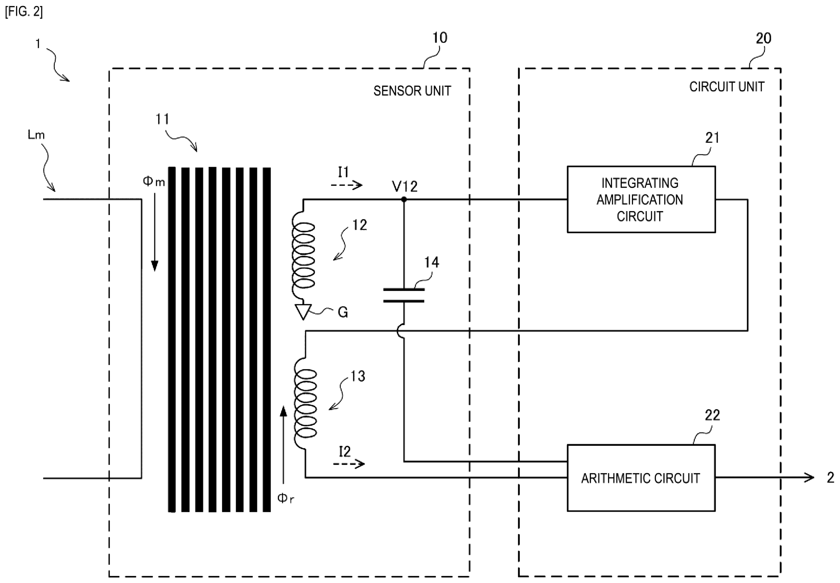

In the first embodiment, in a case in which the frequency of the measurement current Im is within a first frequency band equal to or lower than the cutoff frequency of a feedback winding 13 (see FIG. 2), the current sensor 1 detects a detection value applied to the measurement current Im by the AC zero flux method. On the other hand, in a case in which the measurement current Im is within a second frequency band higher than the first frequency band, the current sensor 1 detects a detection value applied to the measurement current Im by a current transformer (CT) operation of the measurement object Lm and the feedback winding 13 wound around a magnetic core 11.

Hereinafter, the first frequency band is referred to as a "negative feedback operation region", and the second frequency band is referred to as a "CT operation region". The current sensor 1 outputs a detection value applied to the detected measurement current Im to the measuring unit 2.

The measuring unit 2 calculates a current value of the measurement current Im for the measurement object Lm based on the detection value indicating the magnitude of the voltage obtained by the current sensor 1 from the current sensor 1. The measuring unit 2 is realized by, for example, a power analyzer, a current measuring instrument, or a magnetic field measuring instrument.

Next, a circuit configuration of the current sensor 1 will be described with reference to FIG. 2.

FIG. 2 is a schematic circuit diagram illustrating a circuit configuration of the current sensor 1 according to the first embodiment.

The current sensor 1 includes a sensor unit 10 for detecting measurement magnetic flux generated by the measurement current Im, and a circuit unit 20 for converting an output signal of the sensor unit 10 into a voltage having a magnitude proportional to the magnitude of the measurement magnetic flux.

The sensor unit 10 includes the magnetic core 11, a detection winding 12, the feedback winding 13, and a capacitive element 14. The circuit unit 20 includes an integrating amplification circuit 21 and an arithmetic circuit 22.

The magnetic core 11 is formed to surround the measurement object Lm. An overall shape of the magnetic core 11 is formed in an annular shape through which the measurement object Lm can be inserted. The annular shape here includes a circular shape, an elliptical shape, a rectangular shape, a polygonal shape, and the like.

The magnetic core 11 according to the first embodiment is constituted by, for example, an iron material such as permalloy. The magnetic core 11 may be realized by a hollow structure instead of the iron material.

The detection winding 12 is an AC detection winding wound around the magnetic core 11. The detection winding 12 functions as a magnetic flux detection winding in the negative feedback operation region. For example, the detection winding 12 converts a differential magnetic flux ($\varphi$m - $\varphi$r) between a measurement magnetic flux $\varphi$m in the magnetic core 11 based on the measurement current Im and a counter magnetic flux $\varphi$r generated by the feedback winding 13 into a voltage V12 having a magnitude proportional to a time derivative of the magnitude of the differential magnetic flux. Hereinafter, the differential magnetic flux is referred to as a residual magnetic flux.

The output terminal, which is one end of the detection winding 12, is connected to the input terminal of the integrating amplification circuit 21, and the other end of the detection winding 12 is connected to a reference potential G. The detection winding 12 is wound around all or a part of the magnetic core 11.

The feedback winding 13 is a feedback winding wound around the magnetic core 11 and supplied with a current by the integrating amplification circuit 21. In the feedback winding 13, a current I2 flows by an electromagnetic induction phenomenon so as to cancel the measurement magnetic flux $\varphi$m generated in the magnetic core 11 by the measurement current Im. At this time, the counter magnetic flux $\varphi$r having a direction opposite to the direction of the measurement magnetic flux $\varphi$m is generated in the magnetic core 11.

The feedback winding 13 functions as a current transformer in the CT operation region. At this time, the measurement magnetic flux $\varphi$m generated in the magnetic core 11 only by the feedback winding 13 is converted into a current I2 having a magnitude proportional to the magnitude of the measurement magnetic flux $\varphi$m.

One end of the feedback winding 13 is connected to the output terminal of the integrating amplification circuit 21, and the other end, which is the output terminal of the feedback winding 13, is connected to a first input terminal of the arithmetic circuit 22. The feedback winding 13, similarly to the detection winding 12, is wound around all or a part of the magnetic core 11.

The capacitive element 14 is a capacitive element that bypasses, by AC coupling, a current flowing in the detection winding 12 to the arithmetic circuit 22 without passing through the integrating amplification circuit 21. As the capacitive element 14, a capacitor is used as an example.

One end of the capacitive element 14 is connected between one end of the detection winding 12 and the input terminal of the integrating amplification circuit 21, and the other end of the capacitive element 14 is connected to a second input terminal of the arithmetic circuit 22. The capacitance value of the capacitive element 14 is determined so that, in the CT operation region, the current I1 flowing in the detection winding 12 passes through the capacitive element 14.

In a case in which the frequency of the measurement current Im is within the negative feedback operation region, the capacitive element 14 suppresses direct passage of the current I1 flowing in the detection winding 12 to the arithmetic circuit 22 through the capacitive element 14 itself.

On the other hand, in a case in which the frequency of the measurement current Im is within the CT operation region, the capacitive element 14 outputs the current I1 flowing in the detection winding 12 directly to the arithmetic circuit 22. At this time, as a frequency of the measurement current Im increases, a proportion of the current I1 flowing in the detection winding 12 that passes through the capacitive element 14 increases.

The circuit unit 20 is, for example, a circuit board including a substrate on which the integrating amplification circuit 21 and the arithmetic circuit 22 are mounted.

The integrating amplification circuit 21 functions as an integrating circuit that integrates the voltage V12 between both ends of the detection winding 12. In the first embodiment, the integrating amplification circuit 21 amplifies and integrates the voltage V12 between both ends of the detection winding 12. The integrating amplification circuit 21 supplies the amplified and integrated current to the feedback winding 13.

The arithmetic circuit 22 functions as an addition circuit that adds the current I1 flowing from the detection winding 12 through the capacitive element 14 and the current I2 flowing through the feedback winding 13. In addition, the arithmetic circuit 22 also functions as an IV conversion circuit that converts the current obtained by the addition into a voltage having a magnitude proportional to the magnitude of the current.

The arithmetic circuit 22 outputs, to the measuring unit 2, the detection value having the amplitude that varies in proportion to the current value of the measurement current Im, based on a current I2 flowing in the feedback winding 13 and the current I1 from the detection winding 12 passing through the capacitive element 14.

For example, in a case in which the winding directions of the detection winding 12 and the feedback winding 13 are the same, the arithmetic circuit 22 adds the current I2 flowing through the feedback winding 13 and the current I1 flowing through the detection winding 12. On the other hand, in a case in which the winding directions of the detection winding 12 and the feedback winding 13 are opposite, the arithmetic circuit 22 subtracts the current I2 flowing through the feedback winding 13 from the current I1 flowing through the detection winding 12.

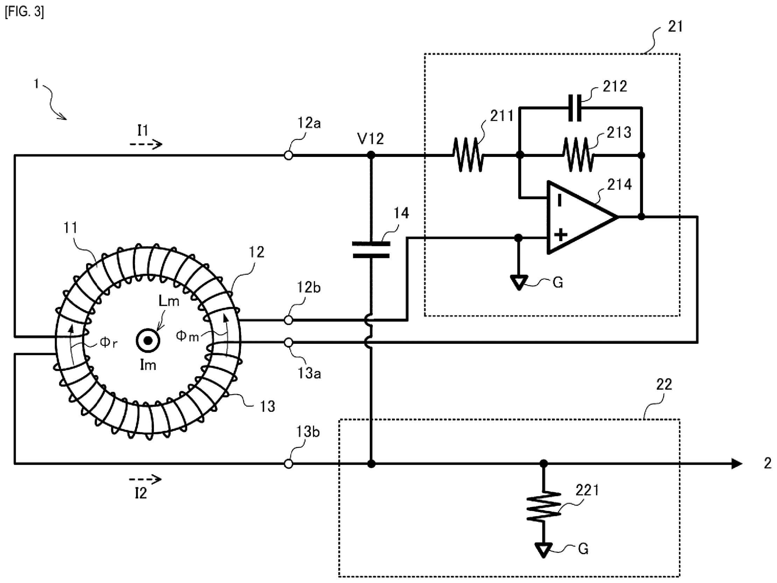

Next, a detailed configuration of the current sensor 1 will be described with reference to FIG. 3.

FIG. 3 is a circuit diagram illustrating a detailed configuration example of the current sensor 1 according to the first embodiment. In the first embodiment, both the detection winding 12 and the feedback winding 13 are wound in the same direction around the circular magnetic core 11, and the number of turns of the detection winding 12 and the number of turns of the feedback winding 13 are the same.

In this example, for convenience, the detection winding 12 and the feedback winding 13 are wound around different portions of the magnetic core 11 from each other, but the detection winding 12 and the feedback winding 13 may be wound around the same portion of the magnetic core 11.

In the feedback winding 13, due to an electromagnetic induction phenomenon, the counter magnetic flux $\varphi r$ that cancels the measurement magnetic flux $\varphi m$ generated in the magnetic core 11 by the measurement current Im is generated, and an induced current flows.

The detection winding 12, by zero flux operation, converts the residual magnetic flux $(\varphi m - \varphi r)$, which is a difference between the measurement magnetic flux $\varphi m$ generated in the magnetic core 11 and the counter magnetic flux $\varphi r$, into a current I1 having a magnitude proportional to the magnitude of the residual magnetic flux $(\varphi m - \varphi r)$, so that the residual magnetic flux $(\varphi m - \varphi r)$ converges to zero.

The one end of the capacitive element 14 according to the first embodiment is connected to one end 12a of the detection winding 12 connected to the input terminal of the integrating amplification circuit 21, and the other end of the capacitive element 14 is connected to the other end 13b of the feedback winding 13 connected to the input terminal of the arithmetic circuit 22.

The integrating amplification circuit 21 includes a resistance element 211, a capacitive element 212, a resistance element 213, and an operational amplifier 214.

In the integrating amplification circuit 21, the one end 12a of the detection winding 12 is connected to one end of the resistance element 211, and the other end of the resistance element 211 is connected to an inverting input terminal (-) of the operational amplifier 214. Then, the capacitive element 212 is connected between the output terminal and the inverting input terminal (-) of the operational amplifier 214, and a resistance element 213 is connected in parallel with the capacitive element 212.

In addition, the other end 12b of the detection winding 12 is connected to a non-inverting input terminal (+) of the operational amplifier 214 and to the reference potential G.

The arithmetic circuit 22 includes a resistance element 221 for converting an incoming current into a voltage having a magnitude proportional to the magnitude of the incoming current, and outputs, to the measuring unit 2, a voltage generated between both ends of the resistance element 211 by the incoming current.

In the arithmetic circuit 22, the other end 13b of the feedback winding 13 is connected to one end of the resistance element 221, and the other end of the resistance element 221 is connected to the reference potential G. Then, the one end of the resistance element 221 is connected, as the output terminal that outputs a voltage proportional to the incoming current, to the input terminal of the measuring unit 2.

In the first embodiment, since the number of turns of the detection winding 12 and the number of turns of the feedback winding 13 are the same, detection sensitivities of both the detection winding 12 and the feedback winding 13 to a change in the magnetic flux generated in the magnetic core 11 are the same.

Therefore, in the CT operation region of the current sensor 1, the current I1 flowing in the detection winding 12 can be directly added to the current I2 flowing in the feedback winding 13 without adjusting output levels of the detection winding 12 and the feedback winding 13. Therefore, the arithmetic circuit 22 can be configured by one resistance element 221.

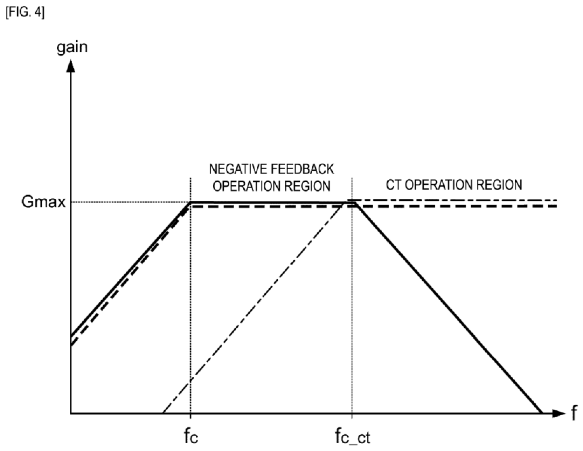

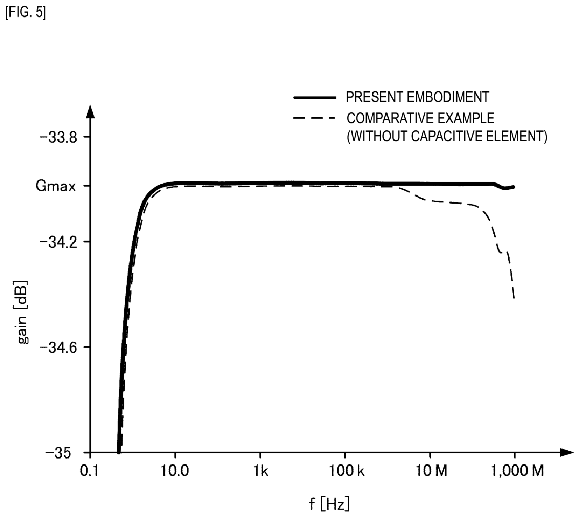

Next, as illustrated in FIGS. 4 and 5, operation of the current sensor 1 will be described.

FIG. 4 is a diagram illustrating gain frequency characteristics of the current sensor 1 in an ideal state. Here, the vertical axis indicates the gain of the current sensor 1, and the horizontal axis indicates the frequency f of the measurement current Im.

In FIG. 4, the gain frequency characteristics of the detection winding 12 are indicated by a solid line, the gain frequency characteristics of the feedback winding 13 are indicated by a dashed-dotted line, and the gain frequency characteristics of the entire current sensor 1 obtained by combining these gain frequency characteristics are indicated by a broken line.

In addition, the maximum gain Gmax indicated on the vertical axis is the maximum value of the gain, and means the maximum value of the conversion efficiency for converting the magnetic flux interlinked with the winding into the current. The maximum gain Gmax is, ideally, a value obtained by dividing the resistance value R of the load resistance by the number of turns N of the detection winding 12 and the feedback winding 13.

Further, the negative feedback operation region defined on the horizontal axis is a frequency band in which the negative feedback operation for causing the magnetic flux generated in the magnetic core 11 by the detection winding 12 to converge to zero is performed, and the CT operation region is a frequency band in which the feedback winding 13 operates as a current transformer.

In the first embodiment, the negative feedback operation region is a frequency band from the cutoff frequency fc of the current sensor 1 including the detection winding 12 and the feedback winding 13 to the cutoff frequency fc_ct of the feedback winding 13. The CT operation region is a frequency band higher than the cutoff frequency fc_ct of the feedback winding 13.

In the negative feedback operation region, the counter magnetic flux φr is generated in the magnetic core 11 in a direction opposite to the direction of the measurement magnetic flux φm by the measurement magnetic flux φm that is linked with the feedback winding 13 among magnetic fluxes generated by the measurement current Im. Therefore, a current is generated in the feedback winding 13 so as to cancel the measurement magnetic flux φm.

At this time, the differential magnetic flux between the measurement magnetic flux φm and the counter magnetic flux φr remains in the magnetic core 11, and the voltage V12 is generated between the one end 12a and the other end 12b of the detection winding 12 by the residual magnetic flux. At this time, a current passing through the capacitive element 14 is substantially zero, and the voltage V12 between the one end 12a and the other end 12b of the detection winding 12 is input to the integrating amplification circuit 21.

The voltage V12 output between the one end 12a and the other end 12b of the detection winding 12 is input to the integrating amplification circuit 21, and the voltage V12 output from the detection winding 12 is integrated and amplified in the integrating amplification circuit 21.

Then, the current output from the integrating amplification circuit 21 is input to one end 13a of the feedback winding 13, and the output current of the integrating amplification circuit 21 and the current generated in the feedback winding 13 are added. As a result, the current I2 having a magnitude obtained by adding the output current of the integrating amplification circuit 21 and the induced current of the feedback winding 13 is output to the arithmetic circuit 22 from the other end 13b of the feedback winding 13.

As illustrated in FIG. 4, as the frequency of a measurement current Im approaches the cutoff frequency fc of the current sensor 1 from a frequency lower than the cutoff frequency fc, the gain of the current sensor 1 monotonically increases, and the gain of the current sensor 1 reaches the maximum gain Gmax near the cutoff frequency fc.

In the negative feedback operation region, the gain of the current sensor 1 is maintained at the maximum gain Gmax, and as the frequency of the measurement current Im becomes higher, the gain of the current transformer configured with the measurement object Lm and the feedback winding 13 monotonically increases toward the maximum gain Gmax.

In the CT operation region, the measurement magnetic flux φm is detected only by the feedback winding 13. At this time, the feedback winding 13 converts the measurement magnetic flux φm into the current I2 having a magnitude proportional to the magnitude of the measurement magnetic flux φm with higher accuracy than in the negative feedback operation region.

That is, a current flows in the feedback winding 13 such that no magnetic flux remains in the magnetic core 11, in other words, such that all of the measurement magnetic flux φm is canceled. Then, only the induced current generated in the feedback winding 13 is output as the current I2 from the other end 13b, and the current I2 is input to the one end of the resistance element 221 in the arithmetic circuit 22.

Here, in the CT operation region, as the frequency of the measurement current Im becomes higher, the magnetic permeability of the magnetic core 11 decreases, and the influence of the parasitic capacitance of each of the detection winding 12 and the feedback winding 13 and the inter-winding capacitance generated between the detection winding 12 and the feedback winding 13 increases. As a result, since the conversion efficiency of the feedback winding 13 decreases, the magnetic flux remains in the magnetic core 11. Accordingly, an induced current flows through the detection winding 12.

Due to the current I2 flowing in the detection winding 12, the gain largely decreases relative to the maximum gain Max near an upper limit of the CT operation region. At this time, since the frequency of the measurement current Im is higher than the negative feedback operation region, the integrating amplification circuit 21 illustrated in FIG. 3 functions as a low-pass filter, and therefore the integrating amplification circuit 21 does not operate, and integration and amplification of the current output from the one end 12a of the detection winding 12 by the operational amplifier 214 are not performed. Therefore, the current flowing in the detection winding 12 is not superimposed on the feedback winding 13 through the integrating amplification circuit 21.

In the first embodiment, since the number of turns of the detection winding 12 and the number of turns of the feedback winding 13 are the same, the current I1 flowing in the detection winding 12 is directly added to the current I2 flowing in the feedback winding 13 through the capacitive element 14. As a result, the decrease in the current I2 associated with the decrease in the conversion efficiency of the feedback winding 13 is compensated.

Then, a current (I1 + I2) obtained by adding the current I1 flowing in the detection winding 12 as an added current to the current I2 flowing in the feedback winding 13 is input to the one end of the resistance element 221 in the arithmetic circuit 22.

Here, the capacitance value of the capacitive element 14 will be briefly described.

The capacitance value of the capacitive element 14 is preferably set such that the current I1 flowing in the detection winding 12 passes through the capacitive element 14 in the CT operation region.

The capacitance value of the capacitive element 14 is determined based on the cutoff frequency of the high-pass filter configured with the capacitive element 14 and the resistance element 221 connected in series. The cutoff frequency fc_hpf of the high-pass filter is calculated, as expressed by the following equation (1), using the capacitance value C of the capacitive element 14 and the resistance value R of the resistance element 221.

$$fc\_hpf = 1/(2\pi CR) \qquad (1)$$

Specifically, the capacitance value C of the capacitive element 14 is determined such that the cutoff frequency fc_hpf of the high-pass filter is higher than the cutoff frequency fc_ct of the feedback winding 13 and is a predetermined frequency lower than the upper limit of the CT operation region.

Note that, the cutoff frequency fc_ct of the feedback winding 13 is calculated, in a case in which the winding resistance value is not taken into consideration, using the inductance value L of the feedback winding 13 and the resistance value R of the resistance element 221, by the following equation (2).

$$fc\_ct = R/(2\pi L) \quad (2)$$

FIG. 5 is a diagram illustrating simulation results of the gain frequency characteristic of the current sensor 1 according to the first embodiment.

Here, the vertical axis indicates the gain of the current sensor 1 on a linear scale, and the horizontal axis indicates the frequency of the measurement current Im on a logarithmic scale. The gain frequency characteristic obtained by the simulation results of the current sensor 1 according to the first embodiment is illustrated by a solid line, and the gain frequency characteristic of a current sensor not including the capacitive element 14 as a comparative example is illustrated by a broken line.

As illustrated in FIG. 5, in the current sensor of the comparative example, as the frequency of the measurement current Im becomes higher from around 1 MHz, the gain gently decreases with respect to the maximum gain Gmax of approximately -34 dB, and steeply decreases from around 20 MHz.

In contrast, in the current sensor 1 according to the first embodiment, even in the high-frequency band in which the gain of the current sensor of the comparative example decreases, the current flowing in the detection winding 12 is supplied, through the capacitive element 14, to the arithmetic circuit 22 that calculates the current flowing in the feedback winding 13.

As a result, in the arithmetic circuit 22, a voltage value corresponding to a magnitude of a current obtained by adding the current I1 flowing in the detection winding 12 to the current I2 flowing in the feedback winding 13 is output. That is, the detection value of the arithmetic circuit 22 is corrected by the current I1 flowing in the detection winding 12.

In this manner, in the current sensor 1 of the first embodiment, by using the current I1 generated in the detection winding 12 accompanying the decrease in the conversion efficiency of the feedback winding 13, the decrease in the current I2 flowing in the feedback winding 13 is compensated. Therefore, in the high-frequency band, a decrease in the gain of the current sensor 1 is suppressed as compared with the current sensor of the comparative example.

Next, actions and effects produced by the current sensor 1 of the first embodiment will be described.

The current sensor 1 according to the first embodiment includes the magnetic core 11 surrounding the measurement object Lm through which the measurement current Im flows, the detection winding 12 functioning as an AC detection winding wound around the magnetic core 11, and the feedback winding 13 functioning as a feedback winding wound around the magnetic core 11. The feedback winding 13 is supplied with a current by the integrating amplification circuit 21 functioning as an integrating circuit that integrates a current flowing in the detection winding 12.

Further, the current sensor 1 includes the capacitive element 14, and outputs a voltage output from the arithmetic circuit 22. The arithmetic circuit 22 adds the current output from the detection winding 12 through the capacitive element 14 and the current output from the feedback winding 13, and converts the current obtained by the addition into a voltage having a magnitude proportional to the magnitude of the current.

According to this configuration, in the CT operation region in which the feedback winding 13 operates as a current transformer, as the frequency of the measurement current Im becomes higher, the proportion at which the current flowing in the detection winding 12 is input to the arithmetic circuit 22 through the capacitive element 14 becomes larger.

At this time, as the frequency of the measurement current Im becomes higher, the magnetic permeability of the magnetic core 11 decreases, and influences of the parasitic capacitance of each of the detection winding 12 and the feedback winding 13 and the inter-winding capacitance between the windings increase. As a result, the magnetic flux canceling operation by the feedback winding 13 is weakened, the magnetic flux remains in the magnetic core 11, and the induced current flows in the detection winding 12. Then, since the detection winding 12 and the feedback winding 13 wound around the magnetic core 11 operate as a current transformer due to the induced current flowing in the detection winding 12, a detection error with respect to the measurement current increases.

Therefore, in the CT operation region, by using the current passing through the capacitive element 14, the detection winding 12 operates as a second feedback winding, and thus a decrease in the induced current in the feedback winding 13 accompanying a decrease in the conversion efficiency of the feedback winding 13 becomes possible to be compensated. Therefore, the detection error with respect to the measurement current Im in the high-frequency region can be suppressed.

In addition, in the first embodiment, the detection winding 12 and the feedback winding 13 have the same numbers of turns.

According to this configuration, by making the number of turns of the detection winding 12 and the number of turns of the feedback winding 13 the same, the degree of influence on the induced current accompanying the decrease in the conversion efficiency of the detection winding 12 and the feedback winding 13 becomes the same. Therefore, since adjusting an output level of the current I2 flowing in the feedback winding 13 and an output level of the current I1 of the detection winding 12 passing through the capacitive element 14 is unnecessary, the current I2 and the current I1 can be directly added.

Accordingly, since the added current can be detected by one resistance element 221 in the arithmetic circuit 22, the arithmetic circuit 22 can be configured with a simple configuration.

In addition, in the first embodiment, the capacitive element 14 is connected between the output terminal of the detection winding 12 and the output terminal of the feedback winding 13.

According to this configuration, since the capacitive element 14 is connected between the output terminal of the detection winding 12 and the output terminal of the feedback winding 13, the capacitive element 14 can be arranged near the detection winding 12 and the feedback winding 13. For this reason, the wiring distance from the output terminal of the detection winding 12 and the output terminal of the feedback winding 13 to the capacitive element 14 can be shortened, as compared with a configuration in which connection is performed on a substrate on which the integrating amplification circuit 21 and the arithmetic circuit 22 are mounted. Accordingly, noise mixed into the capacitive element 14 can be suppressed.

Further, in the first embodiment, the arithmetic circuit 22 includes the resistance element 221, and the capacitive element 14 and the resistance element 221 connected in series constitute a filter. Then, the capacitance value C of the capacitive element 14 is determined such that the cutoff frequency fc_hpf of the filter expressed by equation (1) becomes a predetermined frequency higher than the cutoff frequency fc_ct of the feedback winding 13.

According to this configuration, in the high-frequency band within the CT operation region, the capacitive element 14 can supply the current I1 flowing in the detection winding 12 to the arithmetic circuit 22.

In addition, the current sensor 1 according to the first embodiment includes the integrating amplification circuit 21 and the arithmetic circuit 22.

According to this configuration, the arithmetic circuit 22 can output a detection value in which a detection error caused by a decrease in the conversion efficiency of the feedback winding 13 in the high-frequency band is suppressed.

In addition, the measuring device 100 according to the first embodiment includes the current sensor 1 and the measuring unit 2 that calculates a measurement value for the measurement object Lm based on the detection value detected by the current sensor 1.

According to this configuration, since the detection error caused by the decrease in the conversion efficiency of the feedback winding 13 in the high-frequency band can be suppressed, the accuracy of the measurement value in the high-frequency band can be improved.

In the current sensor 1 of the first embodiment, the numbers of turns of both the detection winding 12 and the feedback winding 13 are configured to be the same from each other, but the numbers of turns may be configured to be different from each other. Therefore, a detailed configuration of the current sensor 1 in which the numbers of turns of the detection winding 12 and the feedback winding 13 are different from each other will be described below as a second embodiment.

Second Embodiment

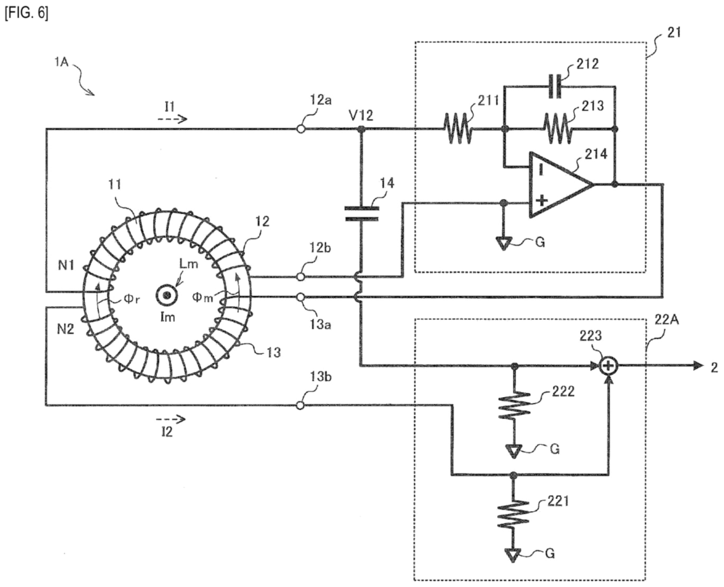

FIG. 6 is a circuit diagram illustrating a detailed configuration of a current sensor 1A according to a second embodiment.

In the second embodiment, the number of turns N1 of a detection winding 12 and the number of turns N2 of a feedback winding 13 are different from each other. Along with this, the current sensor 1A differs from the first embodiment in that the current sensor 1A includes an arithmetic circuit 22A in place of the arithmetic circuit 22 of the current sensor 1 illustrated in FIG. 3, and a connection position of a capacitive element 14 is changed. For this reason, description is provided for points having configurations different from the first embodiment, and description of other configurations is omitted by assigning the same reference numerals.

The arithmetic circuit 22A adjusts an output level of a current I2 flowing in the feedback winding 13 and an output level of a current I1 passing through the capacitive element 14 from the detection winding 12, and outputs an added current value of the adjusted current I2 and the adjusted current I1. The arithmetic circuit 22A includes a resistance element 221, a resistance element 222, and an adder 223.

The resistance element 221 is a second resistor functioning as a second detection element that detects the current I2 flowing in the feedback winding 13. The resistance element 221 outputs, to the adder 223, a voltage having a magnitude proportional to the magnitude of the current I2 flowing in the feedback winding 13.

The resistance value of the resistance element 221 is determined, based on the ratio between the number of turns N1 of the detection winding 12 and the number of turns N2 of the feedback winding 13, such that output levels of both the detection winding 12 and the feedback winding 13 become the same.

Specifically, the resistance value R2 of the resistance element 221 is determined, using the number of turns N1 of the detection winding 12, the number of turns N2 of the feedback winding 13, and the resistance value R1 of the resistance element 222, such that a relationship of the following equation (3) is satisfied.

$$R2/R1 = N2/N1 \quad (3)$$

The resistance element 222 is a first resistor functioning as a first detection element for detecting a current passing through the capacitive element 14 of the current I2 flowing in the detection winding 12. The resistance element 222 outputs, to the adder 223, a voltage having a magnitude proportional to the magnitude of the current flowing in the detection winding 12. The resistance value R1 of the resistance element 222 is determined, similarly to the resistance value R2 of the resistance element 221, such that the relationship of the above equation (3) is satisfied.

The adder 223 adds the voltage generated between both ends of the resistance element 221 and the voltage generated between both ends of the resistance element 222. The adder 223 outputs, to a measuring unit 2, an added voltage that is the added voltage value obtained by addition.

The voltage between both ends of the resistance element 221 and the voltage between both ends of the resistance element 222 indicate voltage values in which the difference in the output level between the detection winding 12 and the feedback winding 13 caused by the difference between the number of turns N2 of the feedback winding 13 and the number of turns N1 of the detection winding 12 is adjusted.

Therefore, even when the detection winding 12 and the feedback winding 13 have the numbers of turns different from each other, a decrease amount of the current I2 accompanying the decrease in the conversion efficiency of the feedback winding 13 can be compensated by use of the current I2 of the detection winding 12 passing through the capacitive element 14.

In the arithmetic circuit 22A, the other end 13b of the feedback winding 13 is connected to one end of the resistance element 221, and the other end of the resistance element 221 is connected to the reference potential G. In addition, one end of the capacitive element 14 is connected to one end 12a of the detection winding 12, the other end of the capacitive element 14 is connected to one end of the resistance element 222, and the other end of the resistance element 222 is connected to the reference potential G.

Then, the one end of the resistance element 222 is connected to a first input terminal of the adder 223, and the one end of the resistance element 221 is connected to a second input terminal of the adder 223. In addition, the input terminal of the measuring unit 2 is connected to the output terminal of the adder 223.

In this manner, even when the detection winding 12 and the feedback winding 13 have the numbers of turns different from each other, by determining each resistance value of the resistance elements 221 and 222 based on a ratio of the number of turns of the respective windings, the decrease amount of the current I2 can be appropriately compensated using the current passing through the capacitive element 14.

Further, the capacitance value of the capacitive element 14 is determined using the above equation (1), similarly to the first embodiment. Specifically, the capacitance value C of the capacitive element 14 is set such that a cutoff frequency fc_hpf of the high-pass filter including the capacitive element 14 and the resistance element 222 connected in series becomes the frequency higher than a cutoff frequency fc_ct of the feedback winding 13.

Next, actions and effects by the current sensor 1A in the second embodiment will be described.

In the second embodiment, the arithmetic circuit 22A includes the resistance element 222 functioning as the first resistor for detecting the current I1 flowing in the detection winding 12, and the resistance element 221 functioning as the second resistor for detecting the current I2 flowing in the feedback winding 13.

In addition, the arithmetic circuit 22A includes the adder 223 functioning as an adder that adds detection values detected by the resistance element 222 and the resistance element 221. Then, the capacitive element 14 is connected between the input terminal of the integrating amplification circuit 21 and the input terminal that is the one end of the resistance element 222.

According to this configuration, by determining the resistance values of the resistance element 222 and the resistance element 221 based on the ratio of the numbers of turns N1 and N2 of the detection winding 12 and the feedback winding 13, adjustment of the output levels of the detection winding 12 and the feedback winding 13 becomes possible.

For example, the one end of the resistance element 222 is connected to the output terminal of the detection winding 12, the one end of the resistance element 221 is connected to the output terminal of the feedback winding 13, and the other end of the resistance element 222 and the other end of the resistance element 221 are respectively connected to the reference potential G. Then, as expressed by the above equation (3), the ratio of the number of turns N1 of the detection winding 12 to the resistance value R1 of the resistance element 222 is equal to the ratio of the number of turns N2 of the feedback winding 13 to the resistance value R2 of the resistance element 221.

According to this configuration, the output levels of the detection winding 12 and the feedback winding 13 having different numbers of turns can be adjusted so that residual magnetic flux ($\varphi$m - $\varphi$r) converges to zero. Therefore, even in a configuration in which the detection winding 12 and the feedback winding 13 have different numbers of turns, in the high-frequency band, by using the current I2 passing through the capacitive element 14 from the detection winding 12, the decrease amount of the current I2 accompanying the decrease in the conversion efficiency of the feedback winding 13 can be appropriately compensated.

Third Embodiment

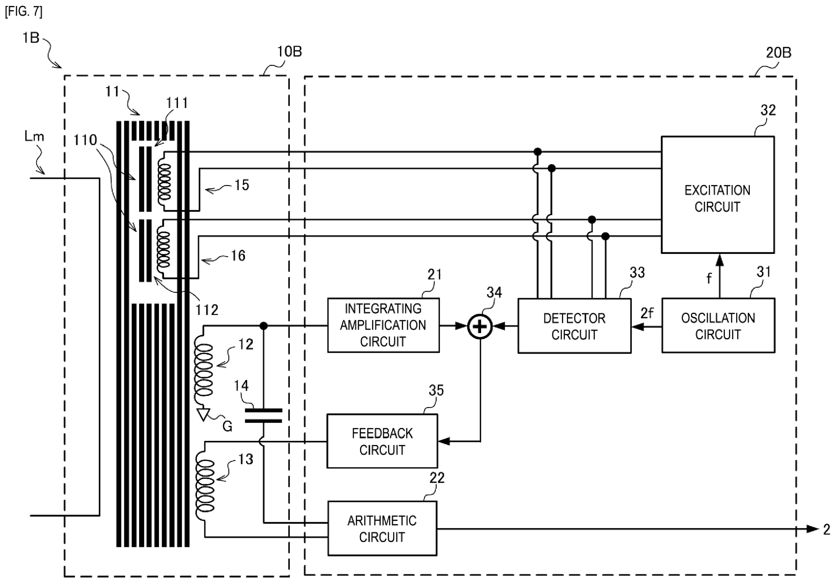

FIG. 7 is a diagram schematically illustrating a configuration of a current sensor 1B in a third embodiment.

The current sensor 1B includes a magnetic detection element in addition to the configuration of the sensor unit 10 illustrated in FIG. 2. In the third embodiment, the current sensor 1B includes a sensor unit 10B and a circuit unit 20B.

The sensor unit 10B includes, in addition to the configuration of the sensor unit 10 illustrated in FIG. 2, a fluxgate 110 as the magnetic detection element arranged in all or a part of an annular magnetic core 11.

In the third embodiment, the fluxgate 110 includes annular magnetic cores 111 and 112, an excitation winding 15 wound around the magnetic core 111, and an excitation winding 16 wound around the magnetic core 112.

The magnetic cores 111 and 112 are, for example, constituted by a permalloy material and are arranged side by side in the magnetic core 11.

The excitation winding 15 and the excitation winding 16 are respectively wound around the magnetic core 111 and the magnetic core 112 so that magnetic fluxes generated in the magnetic core 111 and the magnetic core 112 cancel each other.

The circuit unit 20B includes, in addition to the configuration of the circuit unit 20 illustrated in FIG. 2, an oscillation circuit 31, an excitation circuit 32, a detector circuit 33, an addition circuit 34, and a feedback circuit 35.

The oscillation circuit 31 generates an AC signal having a specific frequency f, and generates a synchronized signal having a doubled frequency 2f obtained by doubling the specific frequency. Then, the oscillation circuit 31 outputs the generated AC signal having the specific frequency f to the excitation circuit 32, and outputs the generated synchronized signal having the doubled frequency 2f to the detector circuit 33.

The excitation circuit 32 generates an AC excitation current having a frequency f based on the AC signal output from the oscillation circuit 31. The excitation circuit 32 outputs the generated AC excitation current to both the excitation winding 15 and the excitation winding 16.

As a result, a magnetic flux is generated in the magnetic core 111, the magnetic flux being a difference between a first magnetic flux generated by the excitation winding 15 and a second magnetic flux generated by the excitation winding 16 and having the direction opposite to the direction of the first magnetic flux.

The detector circuit 33 synchronously detects a differential signal between the voltage signal of the excitation winding 15 and the voltage signal of the excitation winding 16 based on the synchronized signal of the oscillation circuit 31. The detector circuit 33 outputs a signal proportional to the current to be measured generated in the magnetic cores 111 and 112.

The addition circuit 34 adds the output signal of the integrating amplification circuit 21 and the output signal of the detector circuit 33, and outputs the added signal to the feedback circuit 35.

The feedback circuit 35 converts the addition signal obtained from the addition circuit 34 into a current and outputs the current to the feedback winding 13.

In this manner, by including the fluxgate 110 in addition to the configuration of the current sensor 1 or the current sensor 1A, the current sensor 1B can obtain the detection value whose amplitude changes in proportion to the value of the measurement current Im in the frequency band lower than the negative feedback operation region.

Note that, in the third embodiment, the fluxgate 110 has a configuration in which two excitation windings 15 and 16 are wound around the single magnetic core 111, but the present invention is not limited thereto.

For example, the fluxgate 110 may include a configuration including two annular magnetic cores, in which the excitation winding 15 is wound around one magnetic core, and the excitation winding 15 is wound around the other magnetic core. In this case, one magnetic core around which the excitation winding 15 is wound and the other magnetic core around which the excitation winding 16 is wound are arranged side by side in the magnetic core 11.

In addition, in the third embodiment, a configuration in which two excitation windings 15 and 16 are wound around the magnetic core 111 is adopted, but a configuration in which either one of the excitation windings is wound around the magnetic core 11 may be adopted.

Further, in the third embodiment, the fluxgate 110 is used as the magnetic detection element, but a Hall element may be used in place of the fluxgate 110. In this case, the Hall element is arranged in a part of the magnetic core 11, an output signal of the Hall element is input to the addition circuit 34, and, in the addition circuit 34, an output signal of the integrating amplification circuit 21 and the output signal of the Hall element are added.

Next, actions and effects by the current sensor 1B in the third embodiment will be described.

The current sensor 1B in the third embodiment includes the configurations of the first and second embodiments.

According to this configuration, similarly to the actions and effects by the first embodiment and the second embodiment, in the CT operation region, by using the current passing through the capacitive element 14, the decrease in the induced current in the feedback winding 13 accompanying the decrease in the conversion efficiency of the feedback winding 13 can be compensated. Therefore, the detection error with respect to the measurement current Im in the high-frequency region can be suppressed.

In addition, the current sensor 1B in the third embodiment further includes the magnetic detection element detecting magnetic flux generated in the magnetic core 11. As a result, detection accuracy in a frequency band lower than the CT operation region can be enhanced.

Although embodiments of the present invention have been described above, the embodiments merely illustrate part of application examples of the present invention, and no limitation of the technical scope of the present invention to the specific configurations of the embodiments described above is intended.

This application claims priority based on JP 2023-149392 filed to JPO on September 14, 2023, the entire contents of which are incorporated herein by reference.

**REFERENCE SIGNS LIST**

1, 1A, 1B Current sensor
2 Measuring unit
11 Magnetic core
12 Detection winding (AC detection winding)
13 Feedback winding
21 Integrating amplification circuit (integrating circuit)
22 Arithmetic circuit
100 Measuring device
110 Fluxgate (magnetic detection element)
Lm Measurement object
Im Measurement current

**Claims**

**1.** A current sensor comprising:

a magnetic core configured to surround a measurement object with a current flowing therethrough;
an AC detection winding wound around the magnetic core;
a feedback winding wound around the magnetic core and supplied with a current output from an integrating circuit that integrates a voltage between both ends of the AC detection winding; and

a capacitive element,

wherein the current sensor outputs, from an arithmetic circuit that adds a current output from the AC detection winding through the capacitive element and a current output from the feedback winding and converts the added current into a voltage, the converted voltage.

2. The current sensor according to claim 1, wherein the AC detection winding and the feedback winding have an equal number of turns.

3. The current sensor according to claim 1 or 2, wherein the capacitive element is connected between an output terminal of the AC detection winding and an output terminal of the feedback winding.

4. The current sensor according to claim 1,

wherein the AC detection winding and the feedback winding have different numbers of turns,
the arithmetic circuit has a first resistor and a second resistor,
one end of the first resistor is connected to an output terminal of the AC detection winding,
one end of the second resistor is connected to an output terminal of the feedback winding,
another end of the first resistor and another end of the second resistor are respectively connected to a reference potential, and
a ratio of the number of turns of the AC detection winding to a resistance value of the first resistor is equal to a ratio of the number of turns of the feedback winding to a resistance value of the second resistor.

5. The current sensor according to any one of claims 1 to 4, further comprising:
a magnetic detection element configured to detect magnetic flux generated in the magnetic core.

6. The current sensor according to any one of claims 1 to 5,

wherein the arithmetic circuit includes one or more resistance elements,
a capacitance value of the capacitive element is determined such that a cutoff frequency of a filter including the capacitive element and at least one of the resistance elements connected in series becomes a predetermined frequency higher than a cutoff frequency of a current transformer including the feedback winding and the resistance element.

7. The current sensor according to any one of claims 1 to 6,
wherein the current sensor includes the integrating circuit and the arithmetic circuit.

8. A measuring device comprising:

the current sensor according to any one of claims 1 to 7; and
a measuring unit configured to calculate a measurement value of the measurement object based on a detection value detected by the current sensor.

[FIG. 1]

MEASURING DEVICE

100

CURRENT SENSOR

1

Im

Lm

2

MEASURING UNIT

[FIG. 2]

[FIG. 3]

[FIG. 4]

[FIG. 5]

[FIG. 6]

[FIG. 7]

EP 4 779 324 A1

## INTERNATIONAL SEARCH REPORT

International application No.

**PCT/JP2024/032330**

### A. CLASSIFICATION OF SUBJECT MATTER

***G01R 15/18***(2006.01)i; ***G01R 15/20***(2006.01)i; ***G01R 19/00***(2006.01)i
FI:  G01R15/18 C; G01R15/20 A; G01R19/00 M; G01R19/00 A

According to International Patent Classification (IPC) or to both national classification and IPC

### B. FIELDS SEARCHED

Minimum documentation searched (classification system followed by classification symbols)

G01R15/18; G01R15/20; G01R19/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2022-189076 A (HIOKI ELECTRIC WORKS) 22 December 2022 (2022-12-22) | 1-8 |
| A | JP 2-291973 A (HIOKI ELECTRIC WORKS) 03 December 1990 (1990-12-03) | 1-8 |
| A | JP 4-110776 A (HIOKI ELECTRIC WORKS) 13 April 1992 (1992-04-13) | 1-8 |
| A | US 6984979 B1 (EDEL, Thomas G.) 10 January 2006 (2006-01-10) | 1-8 |
| A | US 5150270 A (DOWTY RFL INDUSTRIES, INC.) 22 September 1992 (1992-09-22) | 1-8 |
| A | JP 2008-519269 A (DANFYSIK A/S) 05 June 2008 (2008-06-05) | 1-8 |

☐ Further documents are listed in the continuation of Box C.  ☑ See patent family annex.

| | | |
|---|---|---|
| \* | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **11 October 2024** | **29 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/032330**

| Patent document cited in search report | | | Publication date (day/month/year) | Patent family member(s) | | | Publication date (day/month/year) |
|---|---|---|---|---|---|---|---|
| JP | 2022-189076 | A | 22 December 2022 | US | 2022/0399159 | A1 | |
| | | | | DE | 102022205860 | A1 | |
| | | | | CN | 115469130 | A | |
| JP | 2-291973 | A | 03 December 1990 | (Family: none) | | | |
| JP | 4-110776 | A | 13 April 1992 | (Family: none) | | | |
| US | 6984979 | B1 | 10 January 2006 | (Family: none) | | | |
| US | 5150270 | A | 22 September 1992 | (Family: none) | | | |
| JP | 2008-519269 | A | 05 June 2008 | US | 2008/0122430 | A1 | |
| | | | | WO | 2006/048020 | A1 | |

Form PCT/ISA/210 (patent family annex) (July 2022)

**EP 4 779 324 A1**

**Patent documents cited in the description**

- WO 2008519269 A

- JP 2023149392 A